# EUROPEAN PATENT APPLICATION

(11) **EP 1 213 847 A1**
(43) Date of publication of application: **12.06.2002**
(21) Application number: 00953446.2
(22) Date of filing: 16.08.2000
(51) Int. Cl.: H04B 3/03, H04M 1/58

(54) **TWO-WIRE FOUR-WIRE CONVERTING CIRCUIT FOR COMMUNICATION DEVICE**

(30) Priority: 20.08.1999 JP 23405999
(71) Applicant: Micro M'S Inc., Osaka-shi, Osaka 550-0015 (JP)
(72) Inventor: Hikuma, Hideo, Micro M's Inc., Osaka-shi, Osaka 550-0015 (JP)
(74) Representative: Grünecker, Kinkeldey, Stockmair & Schwanhäusser Anwaltssozietät
(86) International application number: JP0005484
(87) International publication number: WO0115333

(57) **Abstract**

A 2-4 line-conversion circuit is connected between two lines of an input/output terminal capable of bidirectional communications and four lines of an output terminal and an input terminal, wherein the cancellation circuit for canceling the input signal with a signal of equal amplitude and inverse phase is provided with compressors and an expander so as to improve the amount of cancellation.

## Description

### Background of the Invention

### 1. Field of the Invention

The present invention relates to a 2-4 line-conversion circuit disposed between two lines of a bidirectional communication input/output terminal and four lines of a transmission output terminal and a reception input terminal, and particularly a conversion circuit used as a side-tone suppressing circuit between the input/output terminal connected to a telephone line (two lines) and an output terminal connected to a speaker and an input terminal connected to a microphone (four lines).

The present invention also relates to a 2-4 line-conversion circuit employed as an echo-cancellation circuit for canceling the reception-signal component in the transmission signal. The circuit is disposed between the input/output terminal connecting an earphone microphone (two lines) such as a single earphone in a portable telephone or the like that can also be used as a microphone, and an output terminal and an input terminal (four lines). The output terminal is used for outputting transmission signals to the transmission unit in the portable telephone or the like. The input terminal is used for inputting reception signals from the reception unit of the same.

### 2. Description of the Related Art

In a 2-4 line-conversion circuit, a signal input via the input terminal of the conversion circuit is output to an input/output terminal, but is substantially prevented from being output to an output terminal. Conversely, a signal input via the input/output terminal of the conversion circuit is output to the output terminal, but is not output to the input terminal.

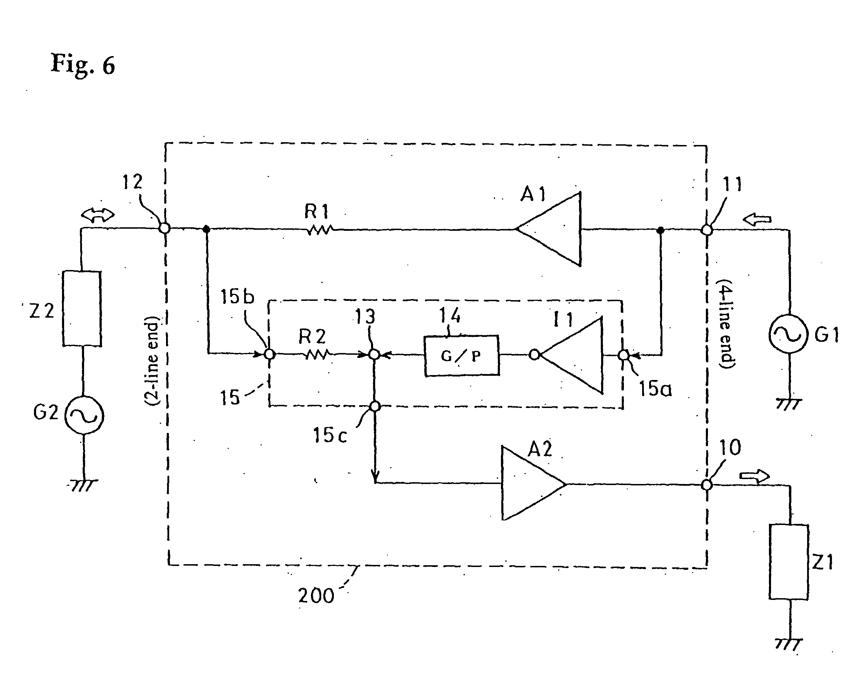

The block diagram in Fig. 6 shows a conventional 2-4 line-conversion circuit that is connected to a telephone line so as to suppress side tones from the telephone microphone from being transmitted to the speaker, that is, to prevent feedback. The circuit can also, be connected between the transmission/reception unit of a cellular-telephone base unit and a transmitter/receiver in order to cancel the reception-signal component in the transmission signal.

Fig. 6 shows a conventional 2-4 line-conversion circuit 200. The 2-4 line-conversion circuit 200 includes an output terminal 10, an input terminal 11, and an input/output terminal 12. Here, the input/output terminal 12 is the two-line end, while the output terminal 10 and input terminal 11 make up the four-line end. The 2-4 line-conversion circuit 200 also includes a reception voltage G1 and an equivalent load resistor Z1 of the input and output terminal, respectively, on the four-line end, and an output voltage G2 and an equivalent load resistor Z2 of the input/output terminal on the two-line end.

Next, the operations of the 2-4 line-conversion circuit 200 will be described. The input signal G1 of the input terminal 11 passes through an op amp amplifier A1 and a resistor R1. The signal is output to the equivalent load resistor Z2 via the input/output terminal 12.

Similarly, the input voltage G2 from the input/output terminal 12 passes through a resistor R2 and an op-amp amplifier A2. The signal is output to the equivalent load resistor Z1 via the output terminal 10.

However, the signal component passing through the output terminal 10 includes the signal component from the input terminal 11 that passed through the amplifier A1, resistor R1, resistor R2, and amplifier A2, which can lead to feedback. Therefore, a branch circuit was further provided between the input terminal 11 and a contact point 13 between the resistor R2 and the amplifier A2. This branch circuit includes an op-amp inverting amplifier 11 and a gain/phase adjusting circuit 14.

A cancellation circuit 15 for canceling the input signal G1 is formed from the branch circuit and the resistor R2. The input signal G1 input into the cancellation circuit 15 via an input terminal 15a has its phase inverted by the inverting amplifier I1. Further, the gain/phase adjusting circuit 14 adjusts the signal to have the same amplitude and the opposite phase as the input signal G1 that is input through an output terminal 15b in the cancellation circuit 15 and that passes through the resistor R2. The components of the input signal G1 are combined at the contact point 13 to cancel each other, and the resulting signal is output via an output terminal 15c.

Accordingly, only the input voltage at the input/output terminal 12 is expected to reach the output terminal 10. In reality, however, it is difficult to completely cancel the input signal G1. Normally, the amount of cancellation is about -30 dB.

In the example described above, the cancellation circuit 15 was added to improve the amount of canceled feedback. In order to increase the cancellation amount to -40 dB or more, each circuit constant in the cancellation circuit 15 must be set accurately. However, even a slight shift in these circuits from the constant values results in a sharp drop in the cancellation amount. Therefore, a stabilized cancellation circuit is limited to about -30 dB.

### Summary of the Invention

In view of the foregoing, it is an object of the present invention to provide a 2-4 line-conversion circuit provided with a cancellation circuit having a compressor and an expander to achieve a stable cancellation amount of about -60 dB.

These and other objects of the present invention will be achieved by a 2-4 line-conversion circuit for a communication device comprising an input/output terminal having two lines for simultaneous input and output; an input terminal; an output terminal that forms four lines with the input terminal, a first amplifying circuit connected between the input terminal and the input/output terminal; a first impedance circuit connected between the input terminal and the input/output terminal in series with the first amplifying circuit; a second impedance circuit connected between the input/output terminal and the output terminal; a second amplifying circuit connected between the input/output terminal and the output terminal in series with the second impedance circuit; a branch circuit connected between a point between the second impedance circuit and the second amplifying circuit and the input terminal and comprising an inverting circuit and a gain/phase adjusting circuit connected in series; a first compressor connected between the input/output terminal and the second impedance circuit; a second compressor connected between the input terminal and the branch circuit; and an expander connected between the second amplifying circuit and the output terminal.

According to another aspect of the present invention, the 2-4 line-conversion circuit serves as a side-tone suppressing circuit with a speaker connected to the output terminal; a microphone connected to the input terminal; and a telephone line connected to the input/output terminal.

According to another aspect of the present invention, the communication device using the 2-4 line-conversion circuit is a portable telephone. One of a magnetic earphone, dynamic earphone, or crystal earphone having a microphone function through bidirectional electric-sound conversion is connected to the input/output terminal. A reception circuit and transmission circuit of the portable telephone base unit are connected to the input terminal and output terminal, respectively and the 2-4 line-conversion circuit is employed as a cancellation circuit for canceling the reception-signal component from the transmission signal.

According to another aspect of the present invention, a 2-4 line-conversion circuit for a communication device comprises an input/output terminal having two lines for simultaneous input and output; an input terminal; an output terminal that forms four lines with the input terminal, an amplifying circuit connected between the input terminal and the input/output terminal; an impedance circuit connected between the input terminal and the input/output terminal in series with the amplifying circuit; a first A/D converter; a first compressor; an expander; a D/A converter connected between the input/output terminal and the output terminal in series with the first A/D converter, the first compressor, and the expander; and a branch circuit connected between a point between the first compressor and the expander and the input terminal and comprising an second A/D converter, a second compressor, and an adaptive digital filter for controlling gain and phase and having a feedback input terminal.

According to another aspect of the present invention, the first and second compressors compress at a logarithmic ratio of 1/2, and the expander expands at a logarithmic ratio of 2. Further, the first and second amplifying circuits are operational amplifier amplifying circuits; the inverting circuit is an operational amplifier inverting/amplifying circuit; and the first and second impedance circuits are resistor circuits.

### Brief Description of the Drawings

In the drawings:
Fig. 1 is a circuit diagram showing a 2-4 line-conversion circuit according to a first embodiment of the present invention.
Fig. 2 is a circuit diagram showing an example of signal levels in the circuit of Fig. 1, wherein the cancellation amount is -30 dB.
Fig. 3 is a block diagram showing a 2-4 line-conversion circuit according to a second embodiment.
Fig. 4 is a graph showing the input and output characteristics for the compressors and expander used in the conversion circuit of the present invention.
Fig. 5 includes explanatory diagrams showing the configuration of a communication device using the 2-4 line-conversion circuit of the present invention, wherein (b) includes an earphone microphone that is a bidirectional earphone having a microphone function and (c) is a speaker microphone that is a bidirectional speaker having a microphone function.
Fig. 6 is a block diagram showing a conventional 2-4 line-conversion circuit.
Fig. 7 is a circuit diagram showing an example of signal levels in the circuit of Fig. 6, wherein the amount of cancellation is -30 dB.

### Description of the Preferred Embodiments

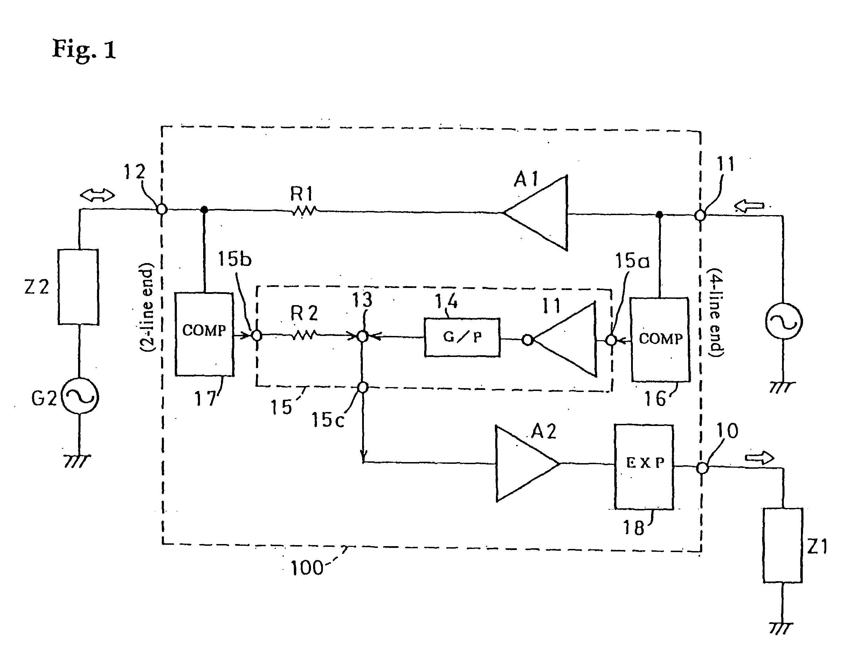

A 2-4 line-conversion circuit according to preferred embodiments of the present invention will be described with reference to the accompanying drawings. Fig. 1 shows a 2-4 line-conversion circuit 100 according to the first embodiment. Components having the same function as those in the conventional circuit of Fig. 6 are indicated with the same part numbers, and a description of these components has been omitted.

In addition to the conventional construction, the 2-4 line-conversion circuit 100 of the present embodiment includes a first compressor 16, a second compressor 17, and an expander 18.

Next, the operations of the 2-4 line-conversion circuit 100 in Fig. 1 will be described. Signals input via the I1 pass through the amplifier A1 (first amplifying circuit) and the resistor R (first impedance circuit) and are output to the equivalent load resistor Z2 via the input/output terminal 12. A voltage G2 input through the input/output terminal 12, on the other hand, passes through the second compressor 17, the resistor R2 (second impedance circuit), the amplifier A2 (second amplifying circuit), and the expander 18 and are output to the equivalent load resistor Z 1 via the output terminal 10.

Here, the component of the signal input via the input terminal 11 is included in the signal that passes through the output terminal 10 due to feedback via the amplifier A1, resistor R1, second compressor 17, resistor R2, amplifier A2, and expander 18. In order to remove this feedback signal, a cancellation circuit for canceling the component of the signal input from the input terminal 11 is formed by the resistor R2 and the branch circuit. The input terminal 11 is connected to the contact point 13 in the cancellation circuit via the first compressor 16 and the branch circuit formed of the inverting amplifier I1 and the gain/phase adjusting circuit 14.

Hence, signals input from the input terminal 11 pass through the first compressor 16 and are input into the cancellation circuit 15 via the input terminal 15a. The signal is phase-inverted by the inverting amplifier I1 and further adjusted in gain and phase by the gain/phase adjusting circuit 14. Accordingly, the signal is adjusted so as to have the same amplitude and the opposite phase of the signal inputted via the output terminal 15b and the resistor R2. The two signals are combined at the contact point 13, thereby canceling the input signal from the input terminal 11. However, the signal input from the input/output terminal is not canceled and is output via the output terminal 15c.

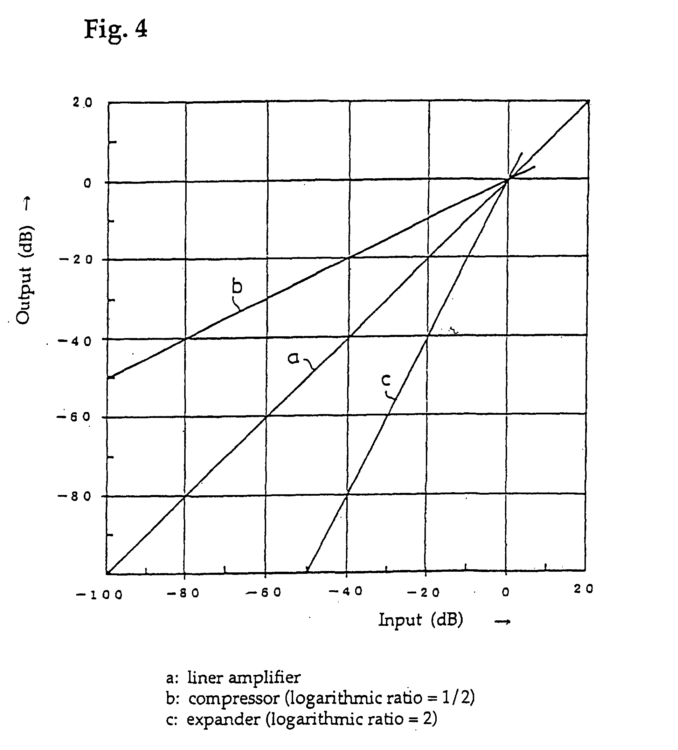

The input/output characteristics of the first compressor 16, second compressor 17, and expander 18 in this circuit are shown in Fig. 4. In the present embodiment, the logarithmic ratio of compression is set at 1/2 and the logarithmic ratio of expansion at 2. These ratios can also be set at 1/3 and 3 or at 1/4 and 4, respectively. However, the sound of the voice will gradually become more unnatural.

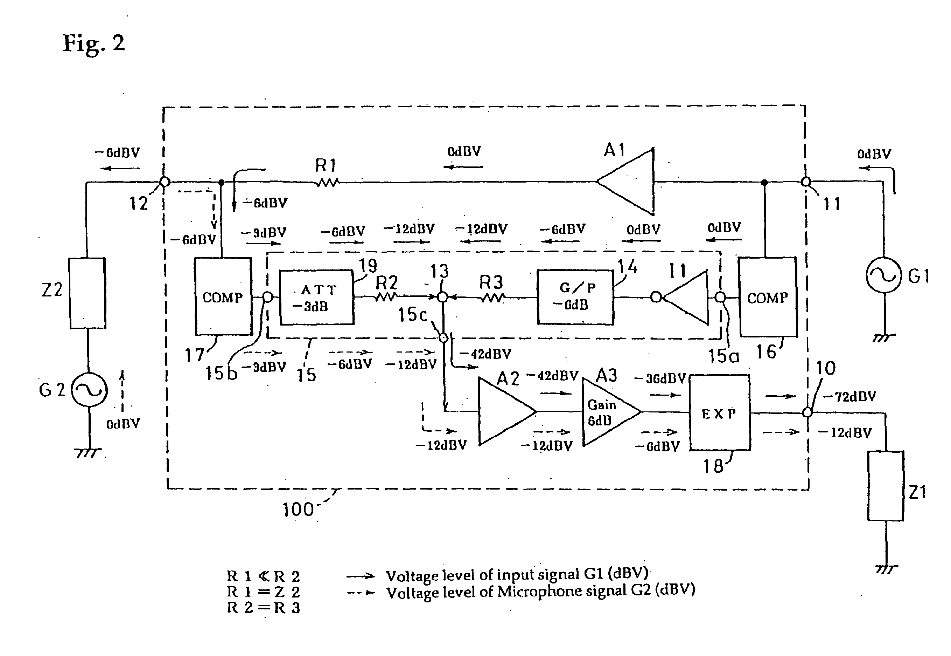

Fig. 2 shows example signal levels for each component in Fig. 1. In this example, the input voltage G1 is set to 0 dBV. Solid arrows are used to indicate the voltage level of this signal. The voltage G2 input from the input/output terminal is set to 0 dBV. Arrows with broken lines are used to indicate the voltage level of this signal in the circuit.

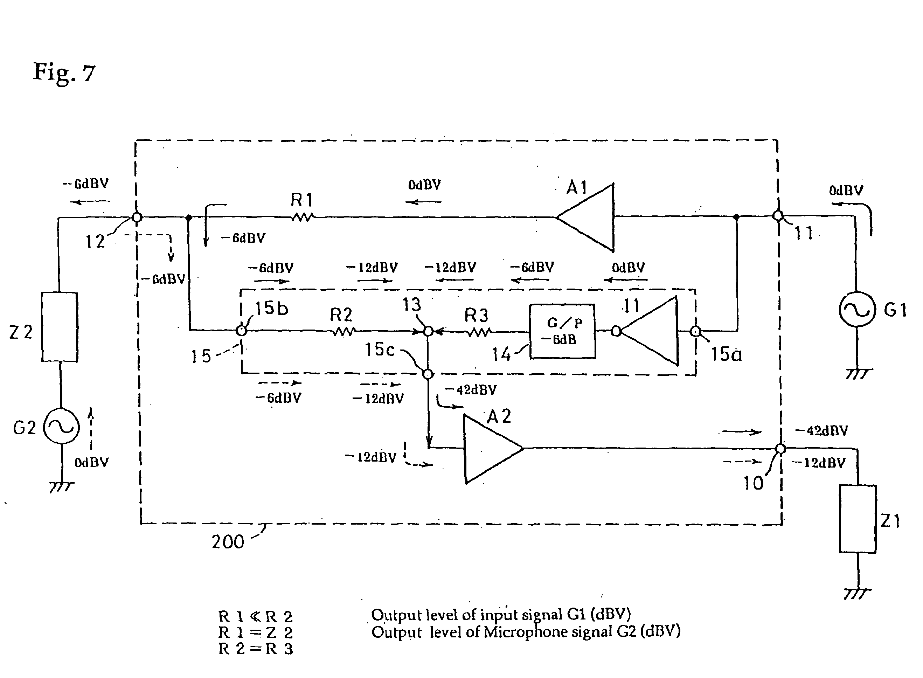

For comparison purposes, Fig. 7 indicates the voltage levels in each component of the conventional circuit in Fig. 6.

For purposes of this description, an attenuator 19 (-3 dB) and an op-amp amplifier A3 (6 dB) have been inserted into the circuit of Fig. 2 in order to set the level of each component the same for Figs. 2 and 7. However, these elements are not necessary. Also, the following relationships were established for simplicity: R1 << R2, R1 = Z2, and R2 = R3.

By comparing the values in Figs. 2 and 7, it can be seen that the conventional circuit of Fig. 7 produces an output-level differential of -30 dB at the output terminal 10, while the circuit of Fig. 2 produces a differential of -60 dB, an improvement of 2 times.

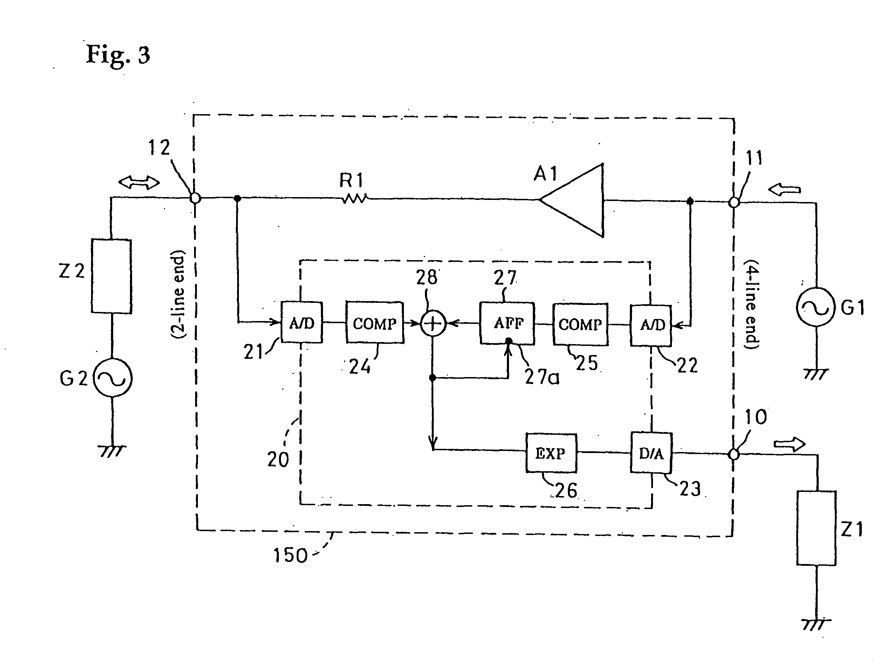

Next, a 2-4 line-conversion circuit according to a second embodiment of the present invention will be described with reference to Fig. 3. In a 2-4 line-conversion circuit 150 shown in Fig. 3, components having the same function as those in the conventional circuit of Fig. 6 are indicated with the same part numbers, and a description of these components has been omitted.

In the diagram, the area 20 is configured of a digital circuit. The 2-4 line-conversion circuit 150 includes first and second A/D converters 21 and 22 for converting analog signals to digital signals, a D/A converter 23 for converting digital signals to analog signals, first and second compressors 24 and 25, an expander 26, an adaptive digital filter 27, a feedback-input terminal 27a provided on the adaptive digital filter 27, and a digital-signal combining circuit 28.

Next, the operations of the 2-4 line-conversion circuit 150 will be described. A signal input via the input terminal 11 passes through the amplifier A1 and resistor R1 and is output to the equivalent load resistor Z2 via the input/output terminal 12. At the same, a signal input via the input/output terminal 12 is converted to a digital signal by the A/D signal converter 21. This digital signal passes through the first compressor 24, the expander 26, and the D/A converter 23 and is converted back to an analog signal. The analog signal is output to the equivalent load resistor Z I via the output terminal 10.

In order to prevent the signal input via the input terminal 11 from being fed back to the output terminal 10, the signal is input into the second A/D converter 22 to generate a digital signal. The digital signal is input into the second compressor 25 and the adaptive digital filter 27. The signal output from the adaptive digital filter 27 is combined with the signal input via the first compressor 24 by the digital-signal combining circuit 28. At this time, the combined signal is input into the feedback-input terminal 27a of the adaptive digital filter 27. The adaptive digital filter 27 adjusts the gain and phase so as to minimize the input signal from the input terminal 11 in the combined signal. In other words, the adaptive digital filter 27 serves as a gain/phase adjusting circuit.

The adaptive digital filter 27 can also compensate for changes in the equivalent load resistor Z2 of the input/output terminal 12.

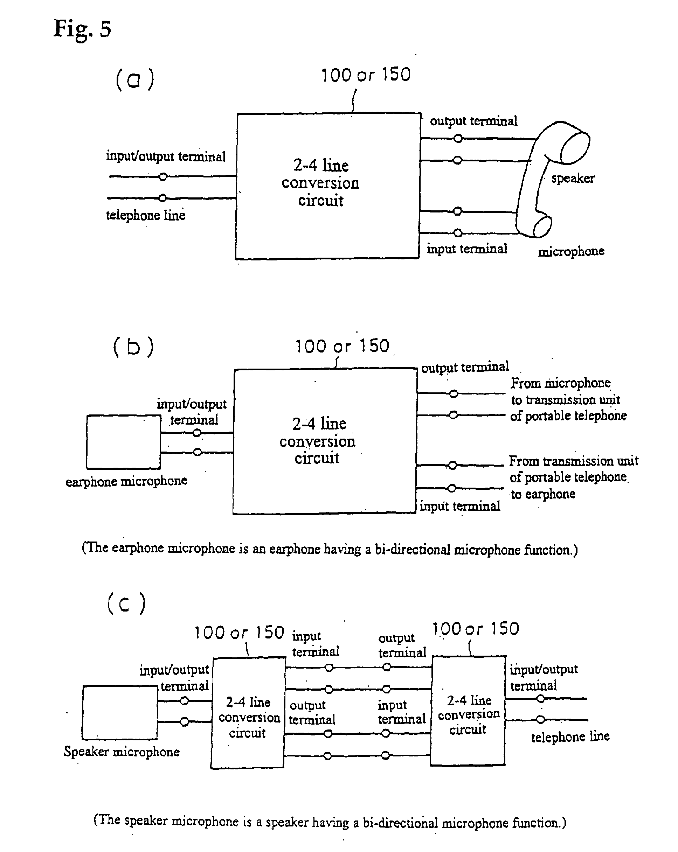

Fig. 5 shows a communication device that employs the full-duplex audio communication circuit 100 or 150 of the present invention. In the communication device of Fig. 5(a), a telephone line is connected to the input/output terminal, a speaker to the output terminal, and a microphone to the input terminal. The 2-4 line-conversion circuit serves as a side-tone suppressing circuit. This conversion circuit can also be applied to a cordless telephone by connecting the terminals for the microphone and speaker to the wave-detection output and modulation input of the base unit in the cordless telephone.

Fig. 5(b) shows a portable telephone, wherein an earphone microphone having a bidirectional earphone with a microphone function is connected to an input/output terminal. An output terminal is connected from the microphone to the transmission unit in the portable telephone. An input terminal is connected from the receiving unit in the telephone to the earphone. A reception signal from the input terminal is canceled, achieving a cancellation amount of approximately -60 dB at the output terminal.

Fig. 5(c) shows a duplex communication device having good feedback characteristics. In this device, a bidirectional speaker microphone having a microphone function is connected to an input/output terminal. Two sets of 2-4 line-conversion circuits are employed, wherein the input terminal of each is connected to the output terminal of the other. Another input/output terminal is connected to a communication line.

A 2-4 line-conversion circuit according to the present invention has the following effects. The 2-4 line-conversion circuit is provided with a cancellation circuit that has compressors and an expander for adjusting gain and phase in order to substantially prevent the input signal from being transmitted to the output terminal. With this circuit, the 2-4 line-conversion circuit can operate with a stable cancellation amount of -60 dB, a considerable improvement over the -30 dB limitation in conventional circuits.

## Claims

1. A 2-4 line-conversion circuit for a communication device comprising:
an input/output terminal having two lines for simultaneous input and output;
an input terminal;
an output terminal that forms four fines with the input terminal;
a first amplifying circuit connected between the input terminal and the input/output terminal;
a first impedance circuit connected between the input terminal and the input/output terminal in series with the first amplifying circuit;
a second impedance circuit connected between the input/output terminal and the output terminal;
a second amplifying circuit connected between the input/output terminal and the output terminal in series with the second impedance circuit;
a branch circuit connected between a point between the second impedance circuit and the second amplifying circuit and the input terminal and comprising an inverting circuit and a gain/phase adjusting circuit connected in series;
a first compressor connected between the input/output terminal and the second impedance circuit;
a second compressor connected between the input terminal and the branch circuit; and
an expander connected between the second amplifying circuit and the output terminal.

2. A 2-4 line-conversion circuit for a communication device as recited in Claim 1, wherein the first and second compressors compress at a logarithmic ratio of 1/2, and the expander expands at a logarithmic ratio of 2.

3. A 2-4 line-conversion circuit for a communication device as recited in Claim 1, wherein the first and second amplifying circuits are operational amplifier amplifying circuits; the inverting circuit is an operational amplifier inverting/amplifying circuit; and the first and second impedance circuits are resistor circuits.

4. A 2-4 line-conversion circuit for a communication device as recited in Claim 1, wherein the circuit serves as a side tone suppressing circuit with a speaker connected to the output terminal; a microphone connected to the input terminal; and a telephone line connected to the input/output terminal.

5. A 2-4 line-conversion circuit for a communication device as recited in Claim 1, wherein the communication device is a portable telephone; one of a magnetic earphone, dynamic earphone, or crystal earphone having a microphone function through bidirectional electric-sound conversion is connected to the input/output terminal; a reception circuit and transmission circuit of the portable telephone base unit are connected to the input terminal and output terminal, respectively; and the 2-4 line-conversion circuit is employed as a cancellation circuit for canceling the reception-signal component from the transmission signal.

6. A 2-4 line-conversion circuit for a communication device comprising:
an input/output terminal having two lines that are connected to one of a magnetic earphone, dynamic earphone, or crystal earphone having a microphone function through bidirectional electric-sound conversion,
an input/output terminal having two lines for simultaneous input and output;
an input terminal;
an output terminal that forms four lines with the input terminal
an amplifying circuit connected between the input terminal and the input/output terminal;
an impedance circuit connected between the input terminal and the input/output terminal in series with the amplifying circuit;
a first A/D converter;
a first compressor;
an expander;
a D/A converter connected between the input/output terminal and the output terminal in series with first A/D converter, the first compressor, and the expander; and
a branch circuit connected between a point between the first compressor and the expander and the input terminal and comprising an second A/D converter, a second compressor, and an adaptive digital filter for controlling gain and phase and having a feedback-input terminal.

7. A 2-4 line-conversion circuit for a communication device as recited in Claim 6, wherein the first and second compressors compress at a logarithmic ratio of 1/2, and the expander expands at a logarithmic ratio of 2.

8. A 2-4 line-conversion circuit for a communication device as recited in Claim 6, wherein the amplifying circuit is an operational amplifier amplifying circuit; and the impedance circuit is a resistor circuit.
